# EUROPEAN PATENT APPLICATION

(11) **EP 2 587 908 A2**
(43) Date of publication of application: **01.05.2013**
(21) Application number: 12397526.0
(22) Date of filing: 22.10.2012
(51) Int. Cl.: H05K 7/20

(54) **A method for providing power supply, and a power supply device**

(30) Priority: 26.10.2011 FI 20116054
(71) Applicant: John Deere Forestry Oy, 33100 Tampere (FI)
(72) Inventor: Hankamäki, Olli, 37420 Valkkinen (FI)
(74) Representative: Pursiainen, Timo Pekka

(57) **Abstract**

A device (1) has been developed for a power supply system of a working machine (26), for supplying electric power to at least one actuator (27a-27c). The device (1) comprises a frame part (2) with a bottom (2b) The device (1) comprises a cooling liquid channel system (9, 10), and the frame part (2) comprises a recess (16) which can be arranged in a flow connection with said cooling liquid channel system (9, 10). The devices can be combined to form modules for the power supply system of the working machine (26), for supplying electric power to at least one actuator (27a-27c), wherein a module (12) comprises two devices (1 a, 1b) placed against each other. The power supply system of the working machine (26) can be composed of the modules.

## Description

### Field of the invention

The present invention relates to a device for an electricity supply system of a working machine, for supplying electric power to at least one actuator, the device comprising a frame part with a bottom and edges. The invention also relates to a module for an electricity supply system of a working machine, as well as to an electricity supply system of a working machine.

### Background of the invention

Various power supply devices are known for supplying electric energy to an electrically powered actuator, such as an electric motor, a pump, lighting, measuring devices, etc. It is an aim of power supply devices to provide conversion of electric power to a format that is applicable for the electrically powered working device. For example, the voltage obtained from an electric power source does not correspond to the operating voltage required by the working device, wherein a power supply device can be used to convert the voltage of the electric power source to a voltage suitable for the working device. On the other hand, the voltage obtained from the electric power source can be an alternating current (AC) voltage, so that if the voltage supplied to the working device has to be a direct current (DC) voltage, a power supply device can be used to convert the AC voltage to the DC voltage. Such power supply devices can also be called AC/DC converters. Situations are also known, in which only a voltage source that supplies DC voltage is available. Thus, if the working machine requires AC voltage as its operating voltage, a power supply device can be used for converting DC voltage to AC voltage. Such power supply devices can also be called DC/AC converters. The DC/AC converter can also be called an alternator or an inverter.

In addition to the above-mentioned AC/DC conversions and DC/AC conversions, the power supply device can change the voltage level, for example convert a higher supply voltage to a lower output voltage, or *vice versa,* that is, convert a lower supply voltage to a higher output voltage.

Power supply devices of the above-described kind can operate in various working machines as electric power converters for electrically powered actuators, wherein for example DC voltage supplied by a battery or an electric generator of a working machine is converted to a voltage suitable for the respective actuator, which may be either DC or AC voltage. All the actuators of the working machine are not necessarily equal in view of electric power supply, wherein there may be a need to use several power supply devices to provide different supply voltages for different actuators. On the other hand, the capacity of a single power supply device is limited, wherein it is not necessarily sufficient for producing the electric power needed by all the actuators, even if the supply voltage requirements were equal for the different actuators. Problems of this type have typically been solved by installing several power supply devices, each providing for one or a few actuators.

Because the conversion of the voltage to a different kind of voltage is not lossless, heat is always formed in the operation of the power supply device, wherein there may be a need to cool the power supply device to prevent it from overheating. This can be arranged, for example, by applying various cooling ribs or other elements which conduct heat formed in the power supply device away from the power supply device, for example by evaporating thermal energy to a medium, such as ambient air. Liquid cooling arrangements are also known, in which a flow channel system for cooling liquid is provided in cooling ribs or in the housing of the power supply device. Thus, heat is conducted to the liquid flowing in the flow channel system and, with the liquid flow, away from the power supply device.

Arrangements of the above presented kind for preventing overheating of power supply devices lead, in practice, to an increase in the size of power supply devices. Furthermore, in arrangements based on a liquid flow, for example, means are needed for accomplishing the circulation of the liquid in the flow pipe system and the cooling of the liquid warmed up in the flow pipe system before the liquid is returned to the flow pipe system. This may add to the size and manufacturing costs of the apparatus.

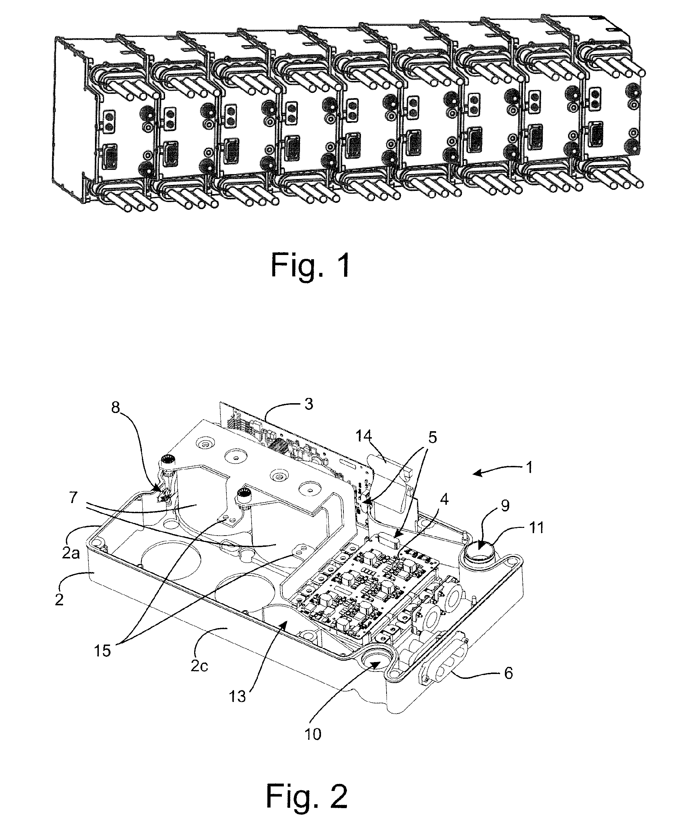

In electrically powered working machines or vehicles, in which several inverters are needed, combining these may be challenging, as is shown in the example of Fig. 1. Each inverter may require a cooling liquid circulation of its own, as well as cabling or bus bars or the like in the DC circuit, motor cables, control cables with communication buses, as well as pilot wires for, for example, temperature and rotational speed sensors. Because of these factors, the assembly may become complex. A possible solution to this problem is to place all the inverters on a single cooling surface and to encapsulate them all within a single housing. However, this approach is not very flexible, because such a device is well adapted to such a working machine only, for which it has been designed.

### Brief summary of the invention

It is an aim of the present invention to provide a modular power supply system, by which it is possible to reduce drawbacks of the solutions of prior art. The present invention is based on the idea of forming the power supply devices pairwise into modular assemblies, wherein the thickness of such a modular power supply device pair can be made smaller than in solutions of prior art, and that the frame of a module can partly act as the cooling liquid channel, whereby the channel system in the frame can be used for distributing cooling liquid to single cooling elements. To put it more precisely, the device according to the present invention is primarily characterized in that the device comprises a cooling liquid channel system, and the frame part comprises a recess which can be arranged in a flow connection with said cooling liquid channel system. The module according to the present invention is primarily characterized in that the devices comprise a cooling liquid channel system, and the frame part of at least one device comprises a recess which can be arranged in a flow connection with said cooling liquid channel system, and that the frame parts of the devices are placed against each other, wherein cooling liquid is arranged to be introduced into the recess for enhancing the cooling of the frame part. The power supply system of the working machine according to the present invention is primarily characterized in that the power supply system of the working machine comprises at least one module, as well as a first end element and a second end element.

By applying the solution according to the invention, it is possible to implement the power supply to working machines with, for example, 8 wheels, 6 wheels, and 4 wheels by providing the power supply system with a corresponding number of power supply devices for the wheel hub motors.

By connecting power supply devices according to the invention together, it is possible to build up an even number of power supply devices, for example 2, 4, 6, or 8 power supply devices. In this embodiment, separate end plates can be installed onto the ends of the assembly. Instead of an end plate, it is also possible to install an element as a replacement for one power supply device, wherein an odd number of power supply devices can be made available as well. Consequently, a water-tight housing can be made advantageously by applying two or three different cast components.

A power supply device according to an advantageous embodiment of the invention only comprises the connectors necessary for the operation, such as an inlet connector and an outlet connector for cooling liquid, motor cables, a connector for a temperature sensor, and a connector for a rotational speed sensor for each motor, and a control cable connector for the whole assembly. The frame can act as the cooling liquid channel; the channel system in the frame can be used for distributing cooling liquid to single cooling elements. The control of the single power supply devices can be implemented inside the housing.

With the present invention, remarkable advantages can be achieved over solutions of prior art. The modular pair of power supply devices according to the invention can be easily changed when needed. Furthermore, more pairs can be installed in case there is a need to increase the number of power supply devices. The cooling of the power supply devices according to the invention can be implemented relatively efficiently in spite of the fact that it has been possible to reduce the thickness of the power supply modules compared with solutions of prior art.

As a further advantage, it can be noted that each power supply module constitutes a part of the housing, wherein no separate housing will be needed around the power supply modules.

By means of the power supply modules according to the invention, it is possible to form assemblies containing the necessary number of power supply devices for each case. A structure of this kind can be made water-tight and protected against interference. In such a structure, the power supply modules are relatively close to each other, wherein no complex wirings are needed.

The power supply modules can be configured such that each module comprises the necessary inlet and outlet connections which are easily accessible, for example in the front or back plate of the device.

### Description of the drawings

In the following, the present invention will be described in more detail with reference to the appended drawings, in which
- Fig. 1: shows an assembly of power supply devices according to the prior art,
- Fig. 2: shows a power supply device according to an advantageous embodiment of the invention in a perspective view,
- Fig. 3: shows a perspective view of a module, in which two power supply devices according to an advantageous embodiment of the invention have been placed against each other,
- Fig. 4: shows an exploded view of power supply devices according to an advantageous embodiment of the invention, combined to form a single power supply system,
- Figs 5a and 5b: show reduced views of an assembly comprising several modules formed by two power supply devices,
- Fig. 5c: illustrates the circulation of cooling liquid in a power supply system according to Figs. 5a and 5b,
- Fig. 6: shows an example of a working machine, in which the power supply system according to the invention can be applied,
- Fig. 7a: shows a frame part according to the example of Fig. 2, seen from the bottom direction, and
- Fig. 7b: shows the frame part according to the example of Fig. 2, seen from the direction opposite to the bottom.

### Detailed description of the invention

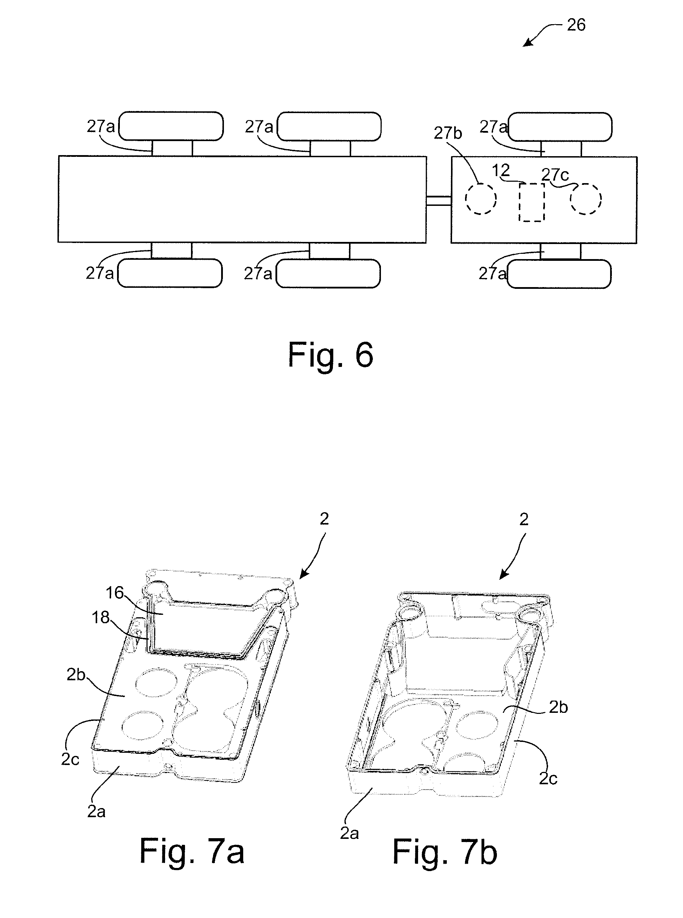

Figure 2 shows a perspective view of a power supply device 1 according to an advantageous embodiment of the invention. The power supply device 1 advantageously comprises a frame part 2, to which a control unit 3 and the other elements enabling the operation of the power supply device are connected, including an output unit 4 for generating an output voltage for actuators 27 to be powered by the power supply unit 1 (Fig. 6), as well as connecting cables 5 for e.g. electrically connecting the control unit 3 and the output unit 4 to each other. The electric energy generated by the power supply device 1 is conducted from the output unit 4 to an output connector 6, from which the electric energy can be conducted, for example, by a cable to an actuator 27. In an advantageous embodiment of the invention, the frame part 2 is simultaneously used as a cooling element.

In this description, the elements 3 to 6 which enable the operation of the power supply device, are also called power supply means.

Some power supply devices 1 comprise a so-called switched-mode power supply for converting DC voltage to AC voltage and for simultaneously increasing the voltage level. In connection with such a switched-mode power supply, there may be a need to use capacitors with a relatively high capacitance value, or other voltage storages suitable for the use. The physical size of such capacitors can be significant with respect to the size of the other components of the switched-mode power supply. In Fig. 2, such capacitors are indicated with the reference numeral 7. In this context, it should be mentioned that the structure and internal operation of the power supply devices applied in connection with the invention may vary in the different embodiments, wherein a more detailed description of the electrical operation of the power supply device will not be necessary for understanding the present invention.

Further, in an advantageous embodiment of the power supply device 1 of Fig. 2, a signal inlet 8 is provided for receiving various measurement signals etc. from measuring devices, such as a motor position sensor and/or temperature sensor. However, these sensors are not shown in the appended drawings.

The frame part 2 of the power supply device 1 according to Fig. 2 is provided with various channels and through-holes, for example for guiding cooling liquid to desired locations. As the cooling liquid, it is possible to use water, glycol or another liquid suitable for the use. In Fig. 2, a first through-hole 9 and a second through-hole 10 have been drawn. A gasket ring or collar or a corresponding sealing element 11 is provided in connection with the first through-hole 9. The first through-hole 9 and the second through-hole 10 have been placed in such a way that when two frame parts 2 of this type are placed against each other, the first through-hole 9 of the frame part 2 of the first power supply device 1a and the second through-hole 10 of the frame part 2 of the second power supply device 1 b are as tightly against each other as possible so that the sealing element 11 seals the flow channel formed by the through-holes 9, 10 as tightly as possible. Thus, the frame parts are placed against each other so that the surfaces 2a shown uppermost in Fig. 2 come against each other in these two frame parts.

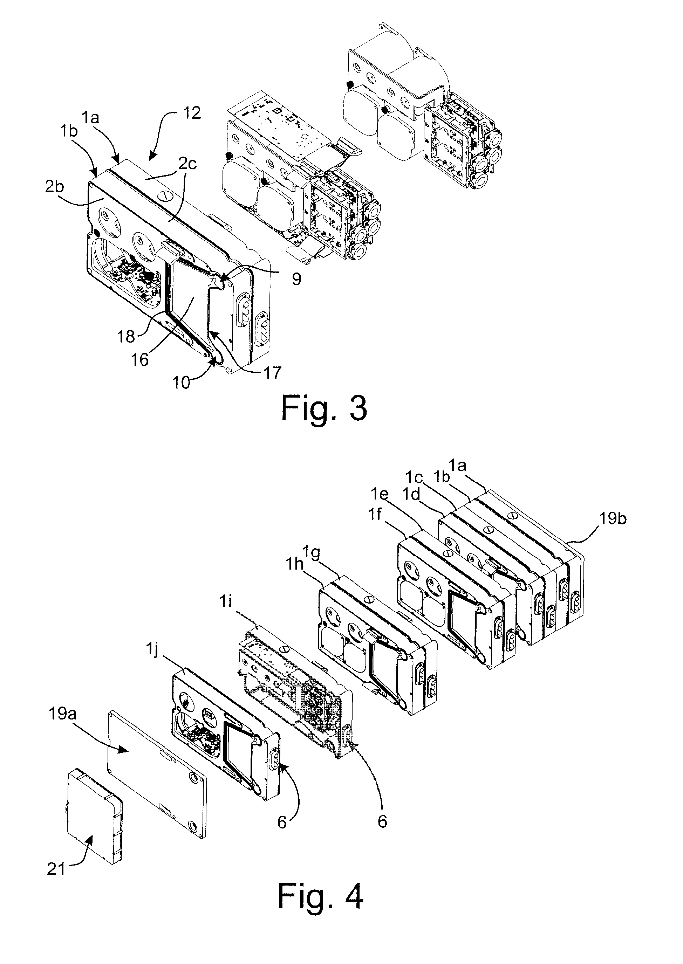

Figure 3 shows a perspective view of a module 12, in which two power supply devices 1a, 1 b have been placed against each other in the above-described way. The frame parts 2 of the two power supply devices 1 a, 1 b are thus, in a way, turned against each other. Thus, the total thickness of these two power supply devices 1 a, 1 b can be made smaller than double the total thickness of one power supply device. In an advantageous embodiment, the height of the edges 2c of the frame part 2 is smaller than the height of the highest part of the power supply means 3 to 6. For example in the case according to the embodiment of Fig. 2, the capacitors 7 of the first power supply device 1 a are placed in such a location in the frame part of the second power supply device 1 b where the thickness of the second power supply device 1 b is smaller. The bottom 2b of the frame part 2 is at least partly solid, and the frame part 2 is substantially open on the side opposite to this bottom 2b. Furthermore, in this embodiment, the edge 2c of the frame part 2 is mirror symmetrical with respect to at least one longitudinal axis, wherein a module formed by two power supply devices 1 a, 1 b can be produced by placing the open sides of the two frame parts 2 against each other, wherein the edges of the frame parts are substantially aligned.

In the embodiment of the power supply device 1 shown in Fig. 2, the frame part 2 is further provided with a through-hole 13 for signal cables, through which holes the signal cables 14 *etc.* can be led out of the frame part 2, for example to the inside of the frame part 2 of the second power supply device 1. For the connection of voltages, the frame part 2 can also be provided with terminal connectors 15 or the like, through which it is possible to conduct, for example, the supply voltage of the power supply devices 1 to the functional blocks inside the module.

Figure 3 shows the bottom 2b of a frame part 2 according to an advantageous embodiment of the invention. The bottom 2b is provided with a recess 16 for enabling the distribution of cooling liquid in the area of the bottom 2b when two such frame parts are installed against each other, with the bottoms together. The cooling liquid is arranged to be led to this recess 16 e.g. through the first through-hole 9 and away from the recess through the second through-hole 10. When two such bottoms 2b are placed together, for example as shown in Fig. 4, the recesses 16 in the bottoms of the adjacent frame parts 2b, 2c are placed together, wherein a hollow is formed, into which the cooling liquid can spread.

The location of the recess 16 in the bottom 2b is advantageously defined so that such electronic components of the power supply device 1 which may heat up during the operation of the power supply device 1 are close to this recess 16. Such electronic components may include, for example, triacs, power transistors (for example MOSFET), IGBT's (Insulated Gate Bipolar Transistor), and/or thyristors which supply electric power to an actuator.

These are placed, for example, in the output unit 4. Components which typically do not heat up so strongly, such as the control unit 3, can be placed in another location in the frame part 2. In the example of Fig. 2, the control unit 3 is placed close to one side 2c of the frame part, wherein heat can be conducted from the control unit 3 to this side 2c of the frame part, from where heat can be transferred to ambient air, for example by radiation.

Around the recess 16, a gasket 17 is advantageously provided for sealing the recess as well as possible and for preventing the entry of cooling liquid out of the recess 16 except through the through-holes 9, 10.

In yet another embodiment, the bottom 2b is provided with a leak channel 18 which makes it possible that if any cooling liquid for any reason leaks out of *e.g.* the recess 16, this leaked cooling liquid will enter the leak channel 18 and further come out of the assembly formed by the frame parts 2 of several power supply devices 1 a, 1 b. In this way, the leak can be detected outside, and the operator of the working machine can take the necessary corrective measures.

Also, Fig. 7a shows the frame part according to the example of Fig. 2 seen from the direction of the bottom 2b. In the bottom, *e.g.* a recess 16 and a leak channel 18 can be seen. Correspondingly, Fig. 7b shows the frame part according to the example of Fig. 2, seen from the direction opposite to the bottom part. It is obvious that the examples of the design and structure of the frame part 2 presented in this application are only some possible alternative implementations, and the applications in practice may vary from those presented in this application.

Figure 4 shows a kind of an exploded view of several power supply devices 1a to 1j which can be combined to form a single power supply system in which neither a separate housing nor separate cooling structures are needed. It may be necessary to connect end elements 19a, 19b to both ends of the power supply system so that the cooling liquid channel can also be sealed for the first power supply device 1 a and the last power supply device 1j. These end elements 19 are advantageously designed so that they close the recess 16 tightly and enable the supply of cooling liquid through the first through-hole 9 and/or the second through-hole 10 to the power supply system. In an advantageous embodiment of the invention, equal end elements 19 can be used at both ends of the power supply system. Furthermore, the power supply system can comprise a main control unit 21 to take care of the functioning of the different parts of the power supply system.

The recess 16 can also be closed to form a hollow in another way than by forming the frame parts mirror symmetrical. In some embodiments, this can be done e.g. by fastening a cover to the frame part 2, wherein by placing two such devices against each other, the cover of one device closes the recess 16 of the other device to form a hollow. Consequently, the frame parts 2 do not need to be mirror symmetrical.

In yet another advantageous embodiment, a cover plate can be fastened onto the recess 16 to close the recess 16 as a hollow. In this case, it is thus not necessary to place two devices against each other to close the recess. Such a cover can be formed, for example, by using the first end element 19a or the second end element 19b shown in Fig. 4. Even in this case, the frame parts 2 do not need to be mirror symmetrical.

In this context, we should also mention an embodiment, in which the frame parts 2 of two or more devices are substantially identical. Thus, when two such frame parts are placed on top of each other to form a module structure, the elements of the cooling liquid channel in the frame part, such as the first through-hole 9 and the second through-hole 10, can be arranged in a flow connection with each other. Also, the recess in one frame part 2 can be closed to form a hollow by means of the other frame part. Even in this case, the frame parts 2 do not need to be mirror symmetrical.

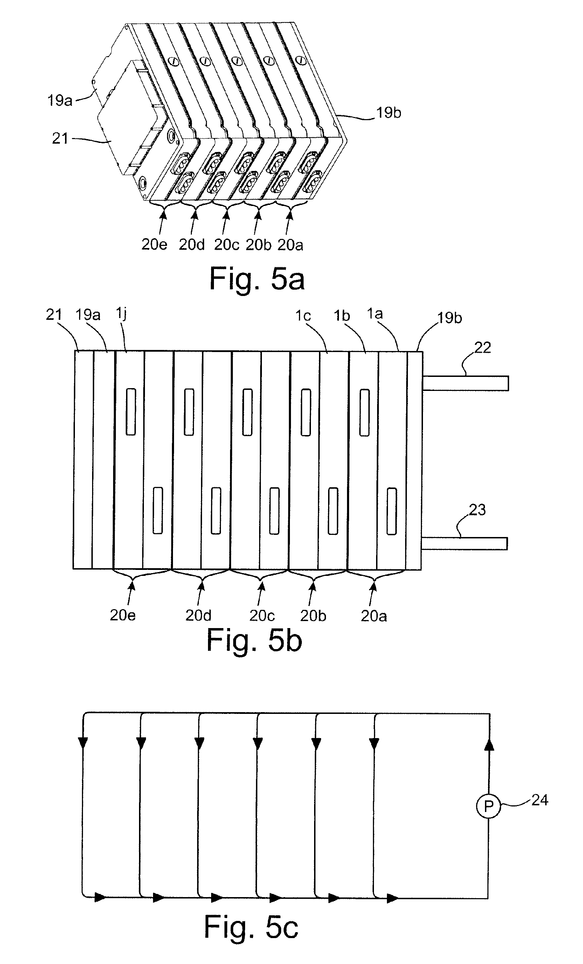

Further, Figs. 5a and 5b show reduced views of such an assembly comprising several modules 20a to 20e formed by two power supply devices, and end elements 19a, 19b. Cooling liquid is introduced via a feed pipe 22 into the first through-hole 9 of the first power supply device 1a, from which the cooling liquid can pass to the recess 16 and through the second through-hole 10 to a discharge pipe 23. Cooling liquid can also enter the cooling liquid circulation of the second power supply device 1 b via the second through-hole 10 of the second power supply device 1 b. From the cooling liquid circulation of the second power supply device 1b, cooling liquid can exit, for example, via the first through-hole 9 of the second power supply device 1b and the second through-hole 10 of the first power supply device 1a to the discharge pipe 23. Furthermore, cooling liquid can also be passed to the cooling liquid circulation of the other power supply devices 1c to 1j in the above described way. Figure 5c illustrates, in a reduced manner with arrows, the cooling liquid circulation in an advantageous embodiment of the power supply system of Figs. 5a and 5b. The cooling liquid circulation is generated by, for example, a pump 24.

With the present invention, it is thus possible to provide a modular power supply system for electrically powered working machines 26. One example of such a working machine 26 is shown in Fig. 6. The working machine 26 can be provided with various electrically powered actuators 27, such as wheel hub motors 27a, a hydraulic pump 27b, etc. The working machine 26 can also comprise a generator 27c for generating electric power for the actuators 27. In some embodiments, the wheel hub motors 27a can also be used as generators, for example in situations, in which the movement of the working machine is decelerated. It is thus possible to couple a required number of power supply devices 1 according to the invention and to provide an assembly suitable for the situation at hand, without having to build up a housing or the like for each different combination.

The replacement and maintenance of power supply devices according to the invention can also be flexibly arranged, because modules which are defective or require maintenance can be easily detached and replaced with modules which are in working order, even at the place where the working machine 26 is used. For the replacement, it is not necessary to consult a person skilled in the art of power supply modules, but e.g. the operator of the working machine can do it. In some cases, the replacement of a power supply device 1 requires the replacement of two power supply devices 1 simultaneously, if they have been combined to form a single module.

In the following, we will present some further examples. One example comprises a device 1 for a power supply system of a working machine 26, for supplying electric power to at least one actuator 27a-27c, the device 1 comprising a frame part 2 with a bottom 2b and edges 2c, and the edges 2c of the frame part are formed mirror symmetrical with respect to a longitudinal axis of the frame part 2.

In one embodiment, the bottom 2b of the frame part 2 is provided with a recess 16 for cooling liquid, the recess 16 being in flow connection with said cooling liquid channel system 9, 10.

In one embodiment, the device 1 comprises power supply means 3 to 6 for generating electric power to be supplied to the actuator 27a-27c.

In an embodiment, the height of the edges 2c of the frame part 2 is smaller than the height of the highest part of the power supply means 3 to 6.

In an embodiment, the device 1 comprises a cooling liquid channel system 9, 10.

In an embodiment, the power supply means 3 to 6 comprise an inverter for converting a supply voltage to a voltage suitable for the actuator 27a-27c.

In another example, a module 12 is provided for a power supply system of a working machine 26, for supplying electric power to at least one actuator 27a-27c, the module 12 comprising two devices 1 a, 1 b having a frame part 2 with a bottom 2b and edges 2c, and the edges 2c of the frame parts of the devices 1a, 1b are formed mirror symmetrical with respect to a longitudinal axis of the frame parts 2 of the device 1 a, 1 b, and that the frame parts 2 of the devices 1 a, 1 b are placed against each other.

In an embodiment, the power supply system of the working machine 26 comprises at least one module, as well as a first end element 19a and a second end element 19b.

In an embodiment of the electric power supply system of the working machine 26, at least one device 1 a, 1 b comprises a cooling liquid channel system 9, 10 with at least a first through-hole 9 and a second through-hole 10, wherein cooling liquid is arranged to be introduced into the cooling liquid channel system 9, 10 via the first through-hole 9 and discharged from the cooling liquid channel system 9, 10 via the second through-hole 10.

In yet another embodiment ofhe electric power supply system of the working machine 26, the bottom 2b of the frame part 2 of at least one device is provided with a recess 16 for cooling agent, the recess being in a flow connection with said cooling liquid channel system 9, 10, wherein cooling liquid is arranged to be introduced into the recess 16 for enhancing the cooling of the frame part 2.

The present invention is not limited to the above-presented embodiments, but it can be modified within the scope of the appended claims.

## Claims

1. A device (1) for a power supply system of a working machine (20), for supplying electric power to at least one actuator (27a-27c), the device (1) comprising a frame part (2), **characterized in that** the device (1) comprises a cooling liquid channel system (9, 10), and the frame part (2) comprises a recess (16) which can be arranged in a flow connection with said cooling liquid channel system (9, 10).

2. The device (1) according to claim 1, **characterized in that** the frame part (2) comprises a bottom (2b), in which said recess (16) is provided.

3. The device (1) according to claim 1 or 2, **characterized in that** the recess (16) for cooling liquid in the bottom (2b) of the frame part (2) is arranged to be closed by placing two devices (1) against each other.

4. The device (1) according to claim 2, **characterized in that** the recess (16) for cooling liquid in the bottom (2b) of the frame part (2) is arranged to be closed with an end element (19a, 19b).

5. The device (1) according to claim 1, 2, 3, or 4, **characterized in that** the device (1) comprises power supply means (3-6) for generating electric power to be supplied to the actuator (27a-27c).

6. The device (1) according to claim 5, **characterized in that** the frame (2) part comprises edges (2c) whose height is smaller than the height of the highest part of the power supply means (3 to 6).

7. The device (1) according to claim 6, **characterized in that** the edges (2c) of the frame part are formed mirror symmetrical with respect to a longitudinal axis of the frame part (2).

8. The device (1) according to any of the claims 1 to 7, **characterized in that** the frame part (2) is provided with a leak channel (18) for conveying cooling liquid possibly leaking from the cooling liquid channel system (9, 10) away from the device (1).

9. The device (1) according to any of the claims 1 to 8, **characterized in that** the power supply means (3-6) comprise an inverter for converting a supply voltage to a voltage suitable for the actuator (27a-27c).

10. A module (12) for the power supply system of a working machine (26), for supplying electric power to at least one actuator (27a-27c), the module (12) comprising two devices (1 a, 1 b) having substantially identical frame parts (2), **characterized in that** the devices (1) comprise a cooling liquid channel system (9, 10), and the frame part (2) of at least one device (1 a, 1 b) comprises a recess (16) which can be arranged in a flow connection with said cooling liquid channel system (9, 10), and that the frame parts (2) of the devices (1 a, 1 b) are placed against each other, wherein cooling liquid is arranged to be introduced into the recess (16) for enhancing the cooling of the frame part (2).

11. An electric power supply system in a working machine (26), **characterized in that** the electric power supply system of the working machine (26) comprises at least one module according to claim 10, as well as a first end element (19a) and a second end element (19b).

12. The electric power supply system according to claim 11 for a working machine (26), **characterized in that** the cooling liquid channel system (9, 10) comprises at least a first through-hole (9) and a second through-hole (10), wherein cooling liquid is arranged to be introduced into the cooling liquid channel system (9, 10) via the first through-hole (9) and discharged from the cooling liquid channel system (9, 10) via the second through-hole (10).
